# EUROPEAN PATENT APPLICATION

(11) **EP 4 749 902 A1**
(43) Date of publication of application: **27.05.2026**
(21) Application number: 25213364.0
(22) Date of filing: 04.11.2025
(51) Int. Cl.: H02M 1/44, H02M 3/00, H02M 3/335, H02M 7/48, H02M 7/538

(54) **ELECTRONIC DEVICE WITH A TRIANGULAR-SHAPED FREQUENCY DITHERING PROFILE**

(30) Priority: 21.11.2024 US 202463723413 P; 15.10.2025 US 202519359295
(71) Applicant: Apple Inc., Cupertino, CA 95014 (US)
(72) Inventor: ZHOU, Rui, Campbell (US); ZHU, Guangqi, Morgan Hill (US); PAVICICH, Douglas M., Milpitas (US); RUSSELL, Antoin J., Mountain View (US); EFANOV, Andrew A., Sunnyvale (US); SEN, Indranil S., Cupertino 95014 (US); WALIA, Manjit S., Los Gatos (US); SJOEROOS, Jukka-pekka J., Cupertino 95014 (US); COLBURN, Matthew, Santa Clara (US)
(74) Representative: COPA Copenhagen Patents

(57) **Abstract**

An electronic device may include an inverter. The inverter may receive switching signals based on a dithered clock signal and output corresponding alternating current signals to a wireless power transfer coil. The dithered clock signal may have a plurality of frequency steps during a repeated cycle of the dithered clock signal. The repeated cycle of the dithered clock signal may comprise a step function that approximates a triangular waveform with steps having unique frequency magnitudes during the repeated cycle.

## Description

This application claims priority to U.S. Patent Application No. 19/359,295, filed October 15, 2025, and U.S. Provisional Patent Application No. 63/723,413, filed November 21, 2024, which are hereby incorporated by reference herein in their entireties.

### Field

This relates generally to electronic devices, and, more particularly, to electronic devices with inverters.

### Background

Electronic devices sometimes include inverters that convert direct current (DC) power to alternating current (AC) power. The inverter may use a clock signal at a given frequency to output corresponding alternating current signals. Care should be taken to improve the electromagnetic compatibility of the inverters.

### Summary

An electronic device may include an inverter configured to receive switching signals based on a dithered clock signal and output corresponding alternating current signals to a wireless power transfer coil and control circuitry configured to generate the dithered clock signal.

The dithered clock signal may have a plurality of frequency steps during a repeated cycle of the dithered clock signal, the repeated cycle of the dithered clock signal may comprise a step function that approximates a triangular waveform, and the dithered clock signal may have a unique frequency magnitude at every one of the plurality of frequency steps during the repeated cycle.

The dithered clock signal may have a plurality of frequency steps during a repeated cycle of the dithered clock signal, the repeated cycle of the dithered clock signal may comprise a step function that approximates a triangular waveform, the frequency magnitude may decrease over time during a first subset of the plurality of frequency steps, the frequency magnitude may increase over time during a second subset of the plurality of frequency steps, and each one of the second subset of the plurality of frequency steps may have a frequency magnitude that is between respective frequency magnitudes of a respective two of the first subset of the plurality of frequency steps.

The dithered clock signal may have a plurality of frequency steps during a repeated cycle of the dithered clock signal, the repeated cycle of the dithered clock signal may comprise a step function that approximates a triangular waveform, the triangular waveform may be centered around a frequency designated as the wireless power transmission frequency of the electronic device, an undithered version of the clock signal at the wireless power transmission frequency may have a first maximum emission magnitude at the wireless power transmission frequency, the dithered clock signal may have a second maximum emission magnitude at the wireless power transmission frequency and an additional emission magnitude at a sideband frequency, the second maximum emission magnitude may be less than the first maximum emission magnitude by a first difference, the additional emission magnitude may be less than the first maximum emission magnitude by a second difference, the second difference may be greater than the first difference, and the second difference may be within 1.2 dB of the first difference.

### Brief Description of the Drawings

FIG. 1 is a schematic diagram of an illustrative wireless power system in accordance with some embodiments.
FIG. 2 is a schematic diagram of illustrative wireless power transmitting circuitry and wireless power receiving circuitry in a wireless power system in accordance with some embodiments.
FIG. 3 is a schematic diagram of an illustrative inverter in accordance with some embodiments.
FIG. 4 is a schematic diagram of an illustrative electronic device that includes dithering circuitry in accordance with some embodiments.
FIG. 5 is a graph of an illustrative dithered clock signal in accordance with some embodiments.
FIG. 6 is a graph of an illustrative modulating signal in accordance with some embodiments.
FIG. 7 is a graph of emission as a function of frequency for the illustrative dithered clock signal of FIG. 5 in accordance with some embodiments.
FIG. 8 is a flowchart of an illustrative method for selecting a dithered clock signal in accordance with some embodiments.

### Detailed Description

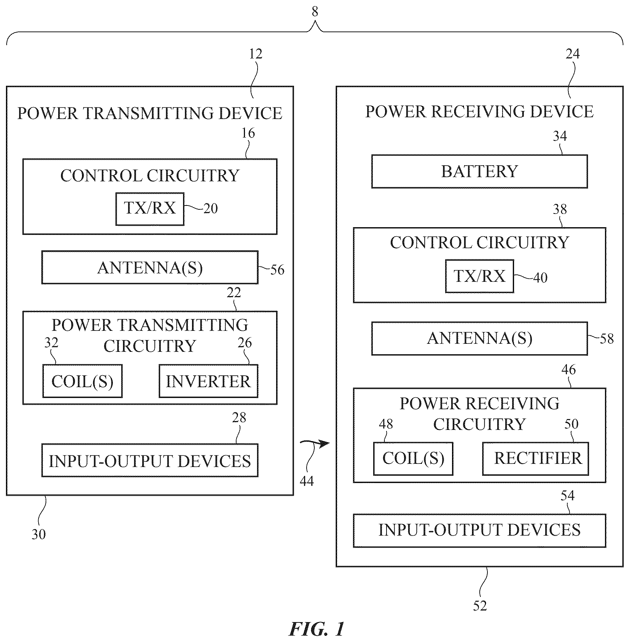

An illustrative wireless power system (also sometimes called a wireless charging system) is shown in FIG. 1. As shown in FIG. 1, wireless power system 8 may include one or more wireless power transmitting devices such as wireless power transmitting device 12 and one or more wireless power receiving devices such as wireless power receiving device 24. Wireless power system 8 may sometimes also be referred to herein as wireless power transfer (WPT) system 8 or wireless power system 8. Wireless power transmitting device 12 may sometimes also be referred to herein as power transmitter (PTX) device 12 or simply as PTX 12. Wireless power receiving device 24 may sometimes also be referred to herein as power receiver (PRX) device 24 or simply as PRX 24.

PTX device 12 includes control circuitry 16. Control circuitry 16 is mounted within housing 30. PRX device 24 includes control circuitry 38 mounted within a corresponding housing 52 for PRX device 24. Exemplary control circuitry 16 and control circuitry 38 are used in controlling the operation of WPT system 8. This control circuitry may include processing circuitry that includes one or more processors such as microprocessors, power management units, baseband processors, digital signal processors, microcontrollers, graphics processing units (GPUs), central processing units (CPUs), application processors (APs), application-specific integrated circuits with processing circuits, and/or other processing circuits. The processing circuitry implements desired control and communications features in PTX device 12 and PRX device 24. For example, the processing circuitry may be used in controlling power to one or more coils, determining and/or setting power transmission levels, generating and/or processing sensor data (e.g., to detect foreign objects and/or external electromagnetic signals or fields), processing user input, handling negotiations between PTX device 12 and PRX device 24, sending and receiving in-band and out-of-band data, making measurements, and/or otherwise controlling the operation of WPT system 8.

Control circuitry in WPT system 8 (e.g., control circuitry 16 and/or 38) is configured to perform operations in WPT system 8 using hardware (e.g., dedicated hardware or circuitry), firmware and/or software. Software code for performing operations in WPT system 8 is stored on non-transitory computer readable storage media (e.g., tangible computer readable storage media) in the control circuitry of WPT system 8. The software code may sometimes be referred to as software, data, program instructions, instructions, or code. The non-transitory computer readable storage media may include non-volatile memory such as non-volatile random-access memory (NVRAM), one or more hard drives (e.g., magnetic drives or solid state drives), one or more removable flash drives or other removable media, or the like. Software stored on the non-transitory computer readable storage media may be executed on the processing circuitry of control circuitry 16 and/or 38.

PTX device 12 may be a stand-alone power adapter (e.g., a wireless charging mat or charging puck that includes power adapter circuitry), may be a wireless charging mat or puck that is connected to a power adapter or other equipment by a cable, may be an electronic device (e.g., a laptop computer, a desktop computer, a computer monitor containing an embedded computer, a tablet computer, a cellular telephone, a media player, or other handheld or portable electronic device, a smaller device such as a wristwatch device, a pendant device, a headphone or earpiece device, a device embedded in eyeglasses, goggles, or other equipment worn on a user's head, or other wearable or miniature device, a television, a computer display that does not contain an embedded computer, a gaming device, a navigation device, a wireless internet-connected voice-controlled speaker, a home entertainment device, a remote control device, a gaming controller, a peripheral user input device, a wireless base station or access point, equipment that implements the functionality of two or more of these devices, or other electronic equipment), may be equipment that has been incorporated into furniture, a vehicle, or other system, may be a removable battery case, or may be other wireless power transfer equipment.

PRX device 24 may be an electronic device such as a laptop computer, a desktop computer, a computer monitor containing an embedded computer, a tablet computer, a cellular telephone, a media player, or other handheld or portable electronic device, a smaller device such as a wristwatch device, a pendant device, a headphone or earpiece device, a device embedded in eyeglasses, goggles, or other equipment worn on a user's head, or other wearable or miniature device, a wireless tracking tag, a television, a computer display that does not contain an embedded computer, a gaming device, a navigation device, a wireless internet-connected voice-controlled speaker, a home entertainment device, a remote control device, a gaming controller, a peripheral user input device, a wireless base station or access point, equipment that implements the functionality of two or more of these devices, or other electronic equipment.

PTX device 12 may be connected to a wall outlet (e.g., an alternating current power source), may be coupled to a wall outlet via an external power adapter, may have a battery for supplying power, and/or may have another source of power. In implementations where PTX device 12 is coupled to a wall outlet via an external power adapter, the adapter may have an alternating-current (AC) to direct current (DC) power converter that converts AC power from a wall outlet or other power source into DC power. If desired, PTX device 12 may include a DC-DC power converter for converting the DC power between different DC voltages. Additionally or alternatively, PTX device 12 may include an AC-DC power converter that generates the DC power from the AC power provided by the wall outlet (e.g., in implementations where PTX device 12 is connected to the wall outlet without an external power adapter). DC power may be used to power control circuitry 16. During operation, a controller in control circuitry 16 uses power transmitting circuitry 22 to transmit wireless power to power receiving circuitry 46 of PRX device 24.

Power transmitting circuitry 22 may have switching circuitry, such as inverter circuitry 26 formed from transistors, that are turned on and off based on control signals provided by control circuitry 16 to create AC current signals through one or more wireless power transmitting coils such as wireless power transmitting coil(s) 32. These coil drive signals cause coil(s) 32 to transmit wireless power. In implementations where coil(s) 32 include multiple coils, the coils may be disposed on a ferromagnetic structure, arranged in a planar coil array, or may be arranged to form a cluster of coils (e.g., two or more coils, 5-10 coils, at least 10 coils, 10-30 coils, fewer than 35 coils, fewer than 25 coils, or other suitable number of coils). In some implementations, PTX device 12 includes only a single coil 32.

As the AC currents pass through one or more coils 32, alternating-current electromagnetic (e.g., magnetic) fields (wireless power signals 44) are produced that are received by one or more corresponding receiver coils such as coil(s) 48 in PRX device 24. In other words, one or more of coils 32 is inductively coupled to one or more of coils 48. PRX device 24 may have a single coil 48, at least two coils 48, at least three coils 48, at least four coils 48, or another suitable number of coils 48. When the alternating-current electromagnetic fields are received by coil(s) 48, corresponding alternating-current currents are induced in coil(s) 48. The AC signals that are used in transmitting wireless power may have any desired frequency (e.g., 100-400 kHz, 1-100 MHz, between 1.7 MHz and 1.8 MHz, less than 2 MHz, between 100 kHz and 2 MHz, 6.78 MHz, 13.56 MHz, etc.). Rectifier circuitry such as rectifier circuitry 50, which contains rectifying components such as synchronous rectification transistors arranged in a bridge network, converts received AC signals (received alternating-current signals associated with wireless power signals 44) from one or more coils 48 into DC voltage signals for powering PRX device 24. Wireless power signals 44 are sometimes referred to herein as wireless power 44 or wireless charging signals 44. Coils 32 are sometimes referred to herein as wireless power transfer coils 32, wireless charging coils 32, or wireless power transmitting coils 32. Coils 48 are sometimes referred to herein as wireless power transfer coils 48, wireless charging coils 48, or wireless power receiving coils 48.

The DC voltage produced by rectifier circuitry 50 (sometime referred to as rectifier output voltage Vrect) may be used in charging a battery such as battery 34 and may be used in powering other components in PRX device 24 such as control circuitry 38, input-output (I/O) devices 54, etc. PTX device 12 may also include input-output devices such as input-output devices 28. Input-output devices 54 and/or input-output devices 28 may include input devices for gathering user input and/or making environmental measurements and may include output devices for providing a user with output.

As examples, input-output devices 28 and/or input-output devices 54 may include a display (screen) for creating visual output, a speaker for presenting output as audio signals, light-emitting diode status indicator lights and other light-emitting components for emitting light that provides a user with status information and/or other information, haptic devices for generating vibrations and other haptic output, and/or other output devices. Input-output devices 28 and/or input-output devices 54 may also include sensors for gathering input from a user and/or for making measurements of the surroundings of WPT system 8.

The example in FIG. 1 of PRX device 24 including battery 34 is illustrative. More generally, an electronic device may include a power storage device 34. Power storage device 34 may be a battery, or may be, for example, a supercapacitor that stores charge.

PTX device 12 and PRX device 24 may communicate wirelessly using in-band or out-of-band-communications. Implementations using in-band communication may utilize, for example, frequency-shift keying (FSK) and/or amplitude-shift keying (ASK) techniques to communicate in-band data between PTX device 12 and PRX device 24. Wireless power and in-band data transmissions may be conveyed using coils 32 and 48 concurrently. When PTX 12 sends in-band data to PRX 24, wireless transceiver (TX/RX) circuitry 20 may modulate wireless charging signal 44 to impart FSK or ASK communications, and wireless transceiver circuitry 40 may demodulate the wireless charging signal 44 to obtain the data that is being communicated. When PRX 24 sends in-band data to PTX 12, wireless transceiver (TX/RX) circuitry 40 may modulate wireless charging signal 44 to impart FSK or ASK communications, and wireless transceiver circuitry 20 may demodulate the wireless charging signal 44 to obtain the data that is being communicated.

Implementations using out-of-band-communication may utilize, for example, hardware antenna structures and communication protocols such as Bluetooth or NFC to communicate out-of-band data between PTX device 12 and PRX device 24. Power may be conveyed wirelessly between coils 32 and 48 concurrently with the out-of-band data transmissions. Wireless transceiver circuitry 20 may wirelessly transmit and/or receive out-of-band signals to and/or from PRX device 24 using an antenna such as antenna 56. Wireless transceiver circuitry 40 may wirelessly transmit and/or receive out-of-band signals to and/or from PTX device 12 using an antenna such as antenna 58.

Antennas 56 and 58 may handle wireless local area network (WLAN) communications bands such as the 2.4 GHz and 5 GHz Wi-Fi^{®} (IEEE 802.11) bands, wireless personal area network (WPAN) communications bands such as the 2.4 GHz Bluetooth^{®} communications band, cellular telephone communications bands such as a cellular low band (LB) (e.g., 600 to 960 MHz), a cellular low-midband (LMB) (e.g., 1400 to 1550 MHz), a cellular midband (MB) (e.g., from 1700 to 2200 MHz), a cellular high band (HB) (e.g., from 2300 to 2700 MHz), a cellular ultra-high band (UHB) (e.g., from 3300 to 5000 MHz, or other cellular communications bands between about 600 MHz and about 5000 MHz (e.g., 3G bands, 4G LTE bands, 5G New Radio Frequency Range 1 (FR1) bands below 10 GHz, etc.), a near-field communications (NFC) band (e.g., at 13.56 MHz), satellite navigations bands (e.g., an L1 global positioning system (GPS) band at 1575 MHz, an L5 GPS band at 1176 MHz, a Global Navigation Satellite System (GLONASS) band, a BeiDou Navigation Satellite System (BDS) band, etc.), ultra-wideband (UWB) communications band(s) supported by the IEEE 802.15.4 protocol and/or other UWB communications protocols (e.g., a first UWB communications band at 6.5 GHz and/or a second UWB communications band at 8.0 GHz), and/or any other desired communications bands.

Antennas 56 and 58 may support communications in Extremely High Frequency (EHF) or millimeter wave communications bands between about 30 GHz and 300 GHz and/or in centimeter wave communications bands between about 10 GHz and 30 GHz (sometimes referred to as Super High Frequency (SHF) bands). As examples, antennas 56 and 58 may support communications in an IEEE K communications band between about 18 GHz and 27 GHz, a Kₐ communications band between about 26.5 GHz and 40 GHz, a Kᵤ communications band between about 12 GHz and 18 GHz, a V communications band between about 40 GHz and 75 GHz, a W communications band between about 75 GHz and 110 GHz, or any other desired frequency band between approximately 10 GHz and 300 GHz. If desired, the millimeter/centimeter wave transceiver circuitry may support IEEE 802.11ad communications at 60 GHz (e.g., WiGig or 60 GHz Wi-Fi bands around 57-61 GHz), and/or 5^{th} generation mobile networks or 5^{th} generation wireless systems (5G) New Radio (NR) Frequency Range 2 (FR2) communications bands between about 24 GHz and 90 GHz.

Antennas 56 and 58 may include antennas with resonating elements that are formed from loop antenna structures, patch antenna structures, inverted-F antenna structures, slot antenna structures, planar inverted-F antenna structures, helical antenna structures, dipole antenna structures, monopole antenna structures, hybrids of these designs, etc. Different types of antennas may be used for different bands and combinations of bands. For example, one type of antenna may be used in forming a local wireless link and another type of antenna may be used in forming a remote wireless link antenna.

Each one of housing 30 and housing 52 may be formed from plastic, metal, fiber-composite materials such as carbon-fiber materials, wood and other natural materials, glass, other materials, and/or combinations of two or more of these materials.

The example in FIG. 1 of PTX 12 transmitting wireless power and PRX 24 receiving wireless power is merely illustrative. PTX 12 may optionally be capable of receiving wireless power signals using coil(s) 32 and PRX 24 may optionally be capable of transmitting wireless power signals using coil(s) 48. When a device is capable of both transmitting and receiving wireless power signals, the device may include both an inverter and a rectifier.

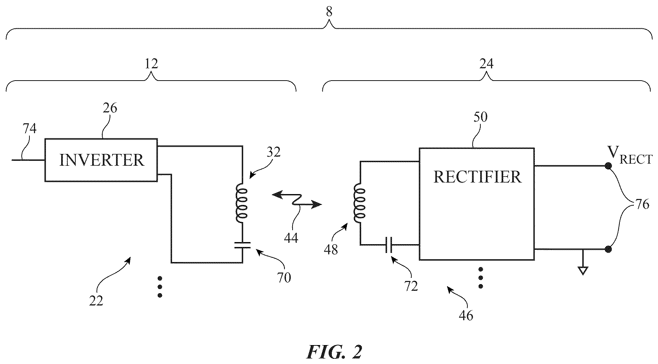

FIG. 2 is a circuit diagram of illustrative wireless charging circuitry for system 8. As shown in FIG. 2, circuitry 22 may include inverter circuitry such as one or more inverters 26 or other drive circuitry that produces wireless power signals that are transmitted through an output circuit that includes one or more coils 32 and capacitors such as capacitor 70. In some embodiments, device 12 may include multiple individually controlled inverters 26, each of which supplies drive signals to a respective coil 32. In other embodiments, an inverter 26 is shared between multiple coils 32 using switching circuitry.

During operation, control signals for inverter(s) 26 are provided by control circuitry 16 at control input(s) 74. A single inverter 26 and single coil 32 is shown in the example of FIG. 2, but multiple inverters 26 and multiple coils 32 may be used, if desired. In a multiple coil configuration, switching circuitry (e.g., multiplexer circuitry) may be used to couple a single inverter 26 to multiple coils 32 and/or each coil 32 may be coupled to a respective inverter 26. During wireless power transmission operations, transistors in one or more selected inverters 26 are driven by AC control signals from control circuitry 16. The relative phase between the inverters may be adjusted dynamically (e.g., a pair of inverters 26 may produce output signals in phase or out of phase).

The application of drive signals using inverter(s) 26 (e.g., transistors or other switches in circuitry 22) causes the output circuits formed from selected coils 32 and capacitors 70 to produce alternating-current electromagnetic fields (signals 44) that are received by wireless power receiving circuitry 46 using a wireless power receiving circuit formed from one or more coils 48 and one or more capacitors 72 in device 24.

Rectifier circuitry 50 is coupled to one or more coils 48 and converts received power from AC to DC and supplies a corresponding direct current output voltage Vrect across rectifier output terminals 76 for powering load circuitry in device 24 (e.g., for charging battery 34, for powering a display and/or other input-output devices 54, and/or for powering other components).

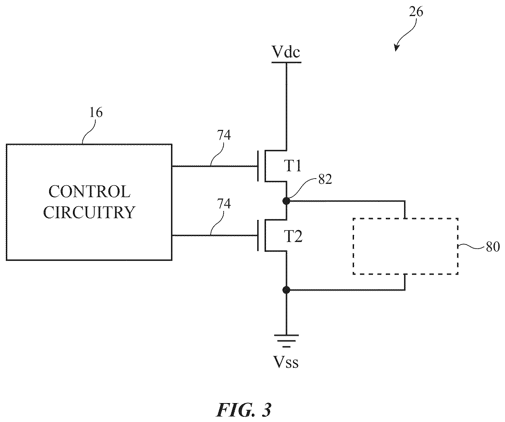

FIG. 3 is a diagram of an illustrative inverter 26 in PTX 12. As shown in FIG. 3, inverter 26 may receive a DC voltage Vdc (e.g., from an AC-DC converter, a battery, etc.). Inverter 26 includes transistors T1 and T2. Each transistor (T1 and T2) has a respective gate 74. Transistors T1 and T2 are coupled in series between a positive voltage terminal (at positive power supply voltage Vdc) and a ground voltage terminal (at ground power supply voltage Vss, sometimes referred to simply as ground voltage Vss).

Control circuitry 16 may produce control signals that are applied to gate terminals 74 of inverter transistors T1 and T2. Gates 74 of transistors T1 and T2 may receive complementary signals so that the gate of transistor T1 is high when the gate of transistor T2 is low, and vice versa. In other words, transistors T1 and T2 are asserted in a mutually exclusive fashion, with T2 being deasserted while T1 is asserted and vice versa.

With one illustrative configuration, transistors T1 and T2 may be supplied with an AC signal (e.g., a clock signal) at a suitable operating frequency with a desired pulse width (or duty cycle) to control the amount of power being transmitted. In general, control signals may be applied to T1 and T2 at any desired frequency. The example of FIG. 3 is merely illustrative and inverter 26 may include additional transistors if desired.

A component 80 may be coupled between node 82 and the ground power supply terminal Vss. Node 82 is interposed between T1 and T2 and may sometimes be referred to as an output node or output of inverter 26. As the control signals are applied to gates 74 of transistors T1 and T2, the DC voltage Vdc is converted into alternating current signals that pass through component 80. Component 80 may be a wireless charging coil (as in FIG. 2), a transformer coil, an antenna, or any other desired component.

Some electronic devices with inverters, such as PTX 12 in FIGS. 1 and 2, may employ signal dithering to improve electromagnetic emission characteristics of the system (e.g., to reduce conducted emission and/or radiated emission). For example, PTX 12 may dither the clock signal that is used to control inverter 26. This effectively dithers the frequency of the alternating current signals output by inverter 26.

Herein, various signals (e.g., clock signals) may be referred to as having corresponding waveforms (e.g., the shape of the voltage of the signal over time). A given waveform may have a recurring shape that repeats at a given frequency (i.e., the given waveform may be periodic). The recurring shape need not necessarily be a regular shape (e.g., a sinusoid). Indeed, the recurring shape may deviate from a sinusoidal shape. However, this type of waveform may still have a frequency associated with the periodic repeating of the non-sinusoidal shape.

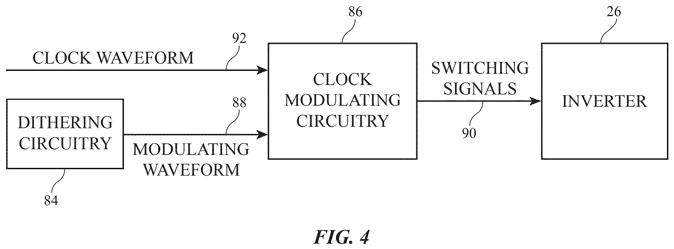

FIG. 4 is a diagram of an illustrative PTX 12 with dithering circuitry. In one possible arrangement, dithering circuitry 84 and clock modulating circuitry 86 may be used to implement a spread spectrum clocking technique (sometimes referred to as clock dithering). Dithering circuitry 84 and clock modulating circuitry 86 may be considered part of control circuitry 16. In spread spectrum clocking, a clock waveform is intentionally modified such that the signal's spectrum is spread around the target frequency for the clock signal. This target frequency is sometimes referred to as the fundamental frequency for the clock signal. This improves the electromagnetic compatibility (EMC) associated with the target frequency of the clock signal. Dithering circuitry 84 may determine a modulating waveform 88 that is used to modulate the clock waveform 92 (sometimes referred to as native clock waveform 92, initial clock waveform 92, undithered clock waveform 92, system clock 92, etc.). To improve EMC, modulating waveform 88 is applied to clock waveform 92 by clock modulating circuitry 86. Clock modulating circuitry 86 may use modulating waveform 88 to frequency modulate clock waveform 92. The resulting switching signals 90 (sometimes referred to as modified clock signal 90, dithered clock signal 90, dithered switching signals 90, etc.) are then provided to inverter 26 to create frequency dithered AC signals.

The modulating waveform 88 output by dithering circuitry 84 may be fixed or may be adjusted based on real time operating conditions of wireless power system 8. For example, dithering circuitry 84 may generate modulating waveform 88 based on a state of charge of battery 34 in PRX 24, an output voltage and/or current of rectifier 50, an output voltage and/or current of coil 48, a voltage and/or current of coil 32, etc.

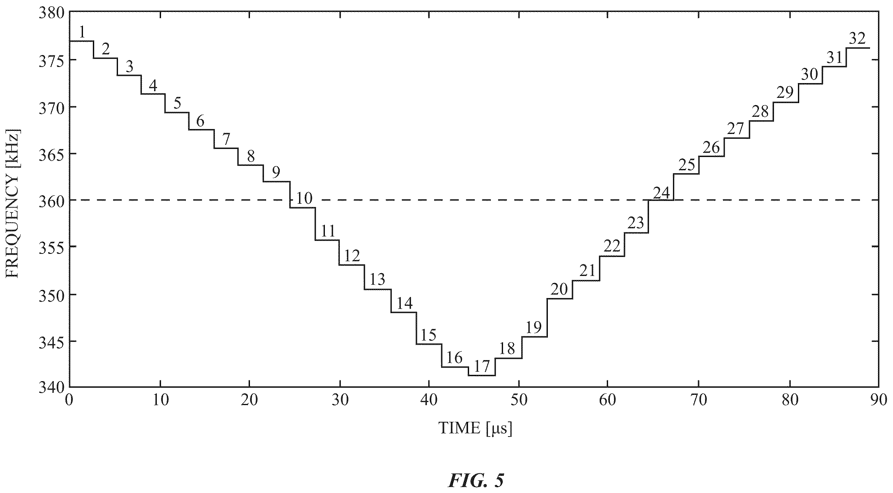

FIG. 5 is a graph of a dithered clock signal that may be provided to inverter 26 in PTX 12. The dithered clock signal of FIG. 5 may be used for a PTX with a designated wireless power transmission frequency (sometimes referred to as the nominal wireless power transmission frequency or simply the wireless power transmission frequency) of 360 kHz. As shown in FIG. 5, the dithered clock signal may be a stepwise function that approximates a triangular waveform. The dithered clock signal may therefore be referred to as having a triangular shape. The dithered clock signal of FIG. 5 may be repeated in a plurality of repeated cycles, each repeated cycle including one period of the waveform shown in FIG. 5. The triangular waveform desirably has a smooth transition between each repeating cycle of the dither pattern.

There are a total of 32 frequency steps in one repeated cycle of the dithered clock signal. FIG. 5 shows the instantaneous frequency of the clock signal over time. The period of each frequency step is equal to 1/fₛ (where fₛ is the instantaneous frequency of the clock signal). In other words, the dithered clock signal remains at each frequency step for exactly one period at the instantaneous frequency associated with that frequency step.

Each one of the 32 frequency steps may have a unique frequency magnitude. The 32 unique frequency steps have a first subset of falling steps (sometimes referred to as decreasing steps) where the frequency magnitude decreases with each subsequent step of the waveform. The 32 unique frequency steps have a second subset of rising steps (sometimes referred to as increasing steps) where the frequency magnitude increases with each subsequent step of the waveform. In the example of FIG. 5, steps 1-17 are the falling steps of the waveform and steps 18-32 are the rising steps of the waveform. The middle step of the rising steps (i.e., step 24) is equal to the wireless power transmission frequency of 360 kHz. The middle step of the falling steps (i.e., step 9) is close to the wireless power transmission frequency of 360 kHz (though not exactly equal to 360 kHz because step 24 is already equal to 360 kHz and each frequency step has a unique frequency magnitude).

Each one of the rising frequency steps may be shifted relative to a corresponding frequency step of the falling frequency steps. The frequency magnitude at step 18 is slightly greater than the frequency magnitude at step 16, the frequency magnitude at step 19 is slightly greater than the frequency magnitude at step 15, the frequency magnitude at step 20 is slightly greater than the frequency magnitude at step 14, etc.

The frequency magnitude at each one of the rising frequency steps may be between a respective two of the frequency magnitudes of the falling frequency steps. The frequency magnitude at step 18 is between the frequency magnitudes of steps 15 and 16, the frequency magnitude at step 19 is between the frequency magnitudes of steps 14 and 15, the frequency magnitude at step 20 is between the frequency magnitudes of steps 13 and 14, etc.

The modulation frequency (fₘ) of the dithered clock signal may be equal to the inverse of the period of the waveform of FIG. 5. Because each frequency step has a duration of one period at the instantaneous frequency at that frequency step and the dithered clock signal is centered around the designated wireless power transmission frequency, the modulation frequency of the dithered clock signal may also be equal to the wireless power transmission frequency divided by the number of steps in the frequency profile. The modulation frequency of the dithered clock signal of FIG. 5 is therefore 11.25 kHz (e.g., 360 kHz / 32 = 11.25 kHz).

The dithered clock signal of FIG. 5 may also have a characteristic frequency deviation Δf. The magnitude of Δf may be equal to the maximum difference between a frequency magnitude of the dithered clocks signal and the wireless power transmission frequency. In the waveform of FIG. 5, frequency step 1 has the maximum frequency and frequency step 17 has the minimum frequency. Frequency step 17 may have the greatest deviation from the wireless power transmission frequency and therefore the magnitude of Δf is equal to 360 kHz minus the frequency at step 17. Herein the frequency at step 17 may be equal to 341.23 kHz and Δf therefore is equal to 18.77 kHz.

The dithered clock signal of FIG. 5 may have a characteristic modulation index (h) that is defined as Δf/fₘ. For the waveform of FIG. 5, the modulation index is equal to 1.67 (e.g., 18.77 kHz / 11.25 kHz = 1.67).

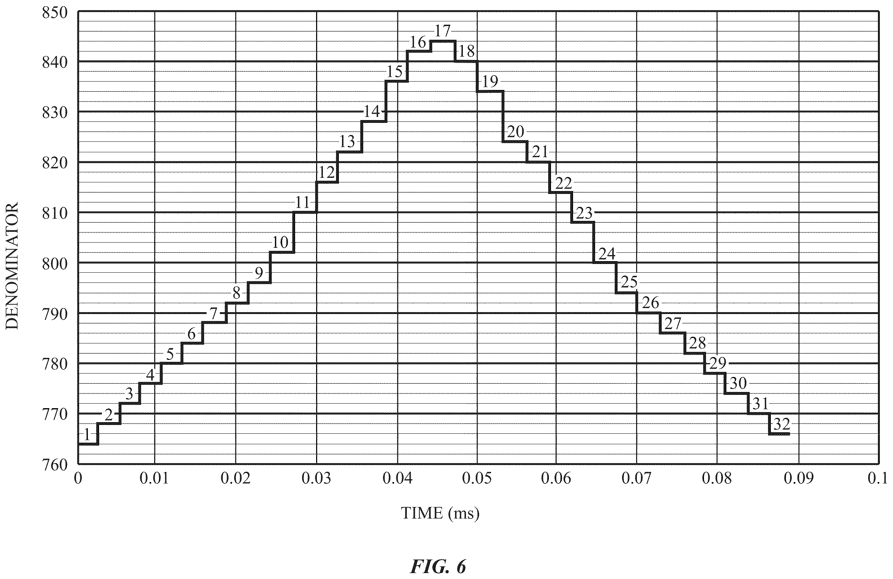

FIG. 6 shows a modulating waveform that may be used to generate the dithered clock signal of FIG. 5. As one example, clock modulating circuitry 86 may modulate clock waveform 92 by dividing the clock frequency by a denominator that is provided by modulating waveform 88. As one example, the system clock frequency may be 288 MHz. The denominator used to divide the system clock frequency is shown in FIG. 6. The waveform of FIG. 6 has 32 steps, with each step corresponding to a respective step in the dithered clock signal of FIG. 5.

As a specific example, the modulating waveform of FIG. 6 may have denominator values of 764, 768, 772, 776, 780, 784, 788, 792, 796, 802, 810, 816, 822, 828, 836, 842, 844, 840, 834, 824, 820, 814, 808, 800, 794, 790, 786, 782, 778, 774, 770, and 766 (in that order). The resulting frequency magnitudes are equal to 376.96 kHz (e.g., 288 MHz/764 = 376.96 kHz), 375.00 kHz (e.g., 288 MHz/768 = 375.00 kHz), 373.06 kHz, 371.13 kHz, 369.23 kHz, 367.35 kHz, 365.48 kHz, 363.64 kHz, 361.81 kHz, 359.10 kHz, 355.56 kHz, 352.94 kHz, 350.36 kHz, 347.83 kHz, 344.50 kHz, 342.04 kHz, 341.23 kHz, 342.86 kHz, 345.32 kHz, 349.51 kHz, 351.22 kHz, 353.81 kHz, 356.44 kHz, 360 kHz, 362.72 kHz, 364.56 kHz, 366.41 kHz, 368.29 kHz, 370.18 kHz, 372.09 kHz, 374.03 kHz, and 375.98 kHz (in that order). For every pair of adjacent frequency steps, the difference between frequency magnitudes may be between 0.5 kHz and 4.5 kHz. The minimum difference between frequency magnitudes of adjacent frequency steps may be 0.81 kHz. The maximum difference between frequency magnitudes of adjacent frequency steps may be 4.19 kHz.

Each one of the 32 unique denominator steps of FIG. 6 may have a unique magnitude. The 32 unique denominator steps have a first subset of rising steps (sometimes referred to as increasing steps) where the denominator magnitude increases with each subsequent step of the waveform. The 32 unique denominator steps have a second subset of falling steps (sometimes referred to as decreasing steps) where the denominator magnitude decreases with each subsequent step of the waveform. In the example of FIG. 6, steps 1-17 are the rising steps of the waveform and steps 18-32 are the falling steps of the waveform.

One or more of the falling denominator steps may be shifted by a constant amount relative to a corresponding denominator step of the rising frequency steps. The magnitude of the shift in FIG. 6 is equal to 2. The denominator magnitude at step 18 is 2 less than the denominator magnitude at step 16, the denominator magnitude at step 19 is 2 less than the denominator magnitude at step 15, the denominator magnitude at step 21 is 2 less than the denominator magnitude at step 13, etc.

The specific examples of FIGS. 5 and 6 are merely illustrative. The modulating frequency fₘ may be greater than 9 kHz, greater than 10 kHz, greater than 11 kHz, greater than 15 kHz, less than 30 kHz, less than 20 kHz, etc. A lower modulating frequency may be desirable for mitigating the magnitude of Δf, which is less stressful to the wireless power system. It may also be desirable for the modulating frequency fₘ to be greater than 9 kHz because 9 kHz is a resolution bandwidth (RBW) used during some electromagnetic interference (EMI) testing protocols.

The magnitude of the modulation index (h) for the dithered clock signal may be less than 2.0, less than 1.9, less than 1.8, less than 1.7, less than 1.6, greater than 1.4, greater than 1.5, greater than 1.6, between 1.4 and 1.8, between 1.5 and 1.7, between 1.6 and 1.7, etc. The magnitude of the frequency deviation (Δf) for the dithered clock signal may be greater than 5 kHz, greater than 10 kHz, greater than 15 kHz, greater than 20 kHz, greater than 30 kHz, less than 20 kHz, less than 15 kHz, between 10 kHz and 30 kHz, between 10 kHz and 20 kHz, etc. The magnitude of the frequency deviation (Δf) for the dithered clock signal may be less than 20% the wireless power transmission frequency, less than 10% the wireless power transmission frequency, less than 5% the wireless power transmission frequency, less than 3% the wireless power transmission frequency, greater than 1% the wireless power transmission frequency, greater than 2% the wireless power transmission frequency, greater than 5% the wireless power transmission frequency, greater than 10% the wireless power transmission frequency, between 1% and 10% of the wireless power transmission frequency, etc.

The dithered clock signal of FIG. 5 may have a time-weighted average frequency that is within 1 kHz of the wireless power transmission frequency (e.g., between 359 kHz and 361 kHz, between 127 kHz and 129 kHz, etc.).

One goal of the frequency dithering scheme herein is to improve EMC at the designated wireless power transmission frequency. In general, greater mitigation in EMI at the designated wireless power transmission frequency is desirable. However, the maximum emission peak associated with the dithered clock signal needs to remain at the wireless power transmission frequency, and not a sideband frequency. In other words, it is desirable for the emission peaks at the sideband frequencies associated with the wireless power transmission frequency to be less than the emission peak at the wireless power transmission frequency. Mitigating the emission peak at the wireless power transmission frequency may cause the emission peaks at the sideband frequencies to increase. The dithering pattern herein may therefore be selected to mitigate the emission peak at the wireless power transmission frequency as much as possible while also ensuring that the emission peaks at the sideband frequencies are less than the emission peak at the wireless power transmission frequency.

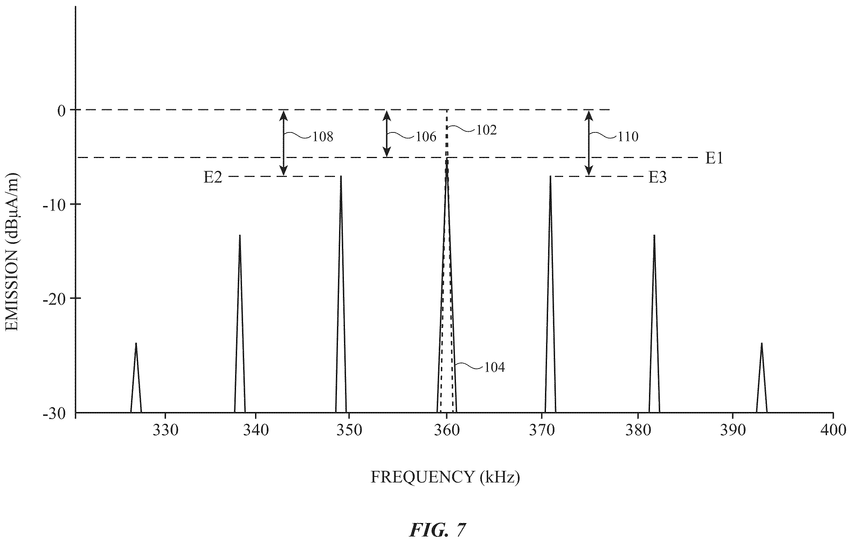

FIG. 7 is a graph of an emission spectrum associated with the dithered clock signal of FIG. 5. The graph shows emission (in units of dBµA/m) as a function of frequency. Differences in emission may have units of dB. The dashed profile 102 shows the emission of an undithered version of the clock signal at the wireless power transmission frequency. For the example of FIGS. 5-7, profile 102 shows the emission of an undithered clock signal at a constant frequency of 360 kHz. The magnitude of profile 102 at 360 kHz may be defined as 0 for the Y-axis scale of FIG. 7.

The solid profile 104 shows the emission of the dithered clock signal of FIG. 5. As shown in FIG. 7, the maximum emission peak for profile 104 has a magnitude E1 and is at the wireless power transmission frequency (e.g., 360 kHz). The emission peak at 360 kHz for profile 104 (e.g., E1) is less than the emission peak for profile 102 at 360 kHz by difference 106. Difference 106 therefore characterizes the EMC improvement at the wireless power transmission frequency. For the dithered clock signal of FIG. 5, the magnitude of difference 106 is -4.8 dB.

Profile 104 has peaks at sideband frequencies in addition to the wireless power transmission frequency. The sideband frequencies may be separated from one another by the modulation frequency of the dithered clock signal. In the example of FIG. 5, the modulation frequency is equal to 11.25 kHz. Therefore, in FIG. 7, each emission peak is separated from the adjacent emission peaks by a frequency of 11.25 kHz.

The emission peaks may become lower with increasing deviation from the wireless power transmission frequency. The dithering pattern of FIG. 5 is selected to ensure that the emission magnitudes at the closest sideband frequencies to the wireless power transmission frequency are less than the emission magnitude at the wireless power transmission frequency. FIG. 7 shows how there is an emission magnitude E2 at a first sideband frequency 348.75 kHz and an emission magnitude E3 at a second sideband frequency 371.25 kHz. The emission magnitude E2 is less than the emission peak for profile 102 by difference 108. The emission magnitude E3 is less than the emission peak for profile 102 by difference 110. For the dithered clock signal of FIG. 5, the magnitude of difference 108 is -5.9 dB and the magnitude of difference 110 is -5.3 dB.

Differences 108 and 110 may be greater than difference 106 to ensure that the peak at the designated wireless power transmission frequency is the maximum emission magnitude for the dithered clock signal. However, differences 108 and 110 may be close to difference 106 to improve the total magnitude of difference 106. Difference 108 may be within 2 dB of difference 106, within 1.5 dB of difference 106, within 1 dB of difference 106, etc. Difference 110 may be within 2 dB of difference 106, within 1.5 dB of difference 106, within 1 dB of difference 106, etc.

The dithering pattern described herein is used for a wireless power transmission frequency of 360 kHz. However, it should be understood that the same concepts may be applied to a dithering pattern regardless of the magnitude of the wireless power transmission frequency. For example, a dithering pattern at any desired wireless power transmission frequency (e.g., 100-400 kHz, 128 kHz, 1-100 MHz, between 1.7 MHz and 1.8 MHz, less than 2 MHz, between 100 kHz and 2 MHz, 6.78 MHz, 13.56 MHz, etc.) may have the number of frequency steps, modulation frequency, waveform shape, frequency deviation, modulation index, and/or emission profile characteristics described herein.

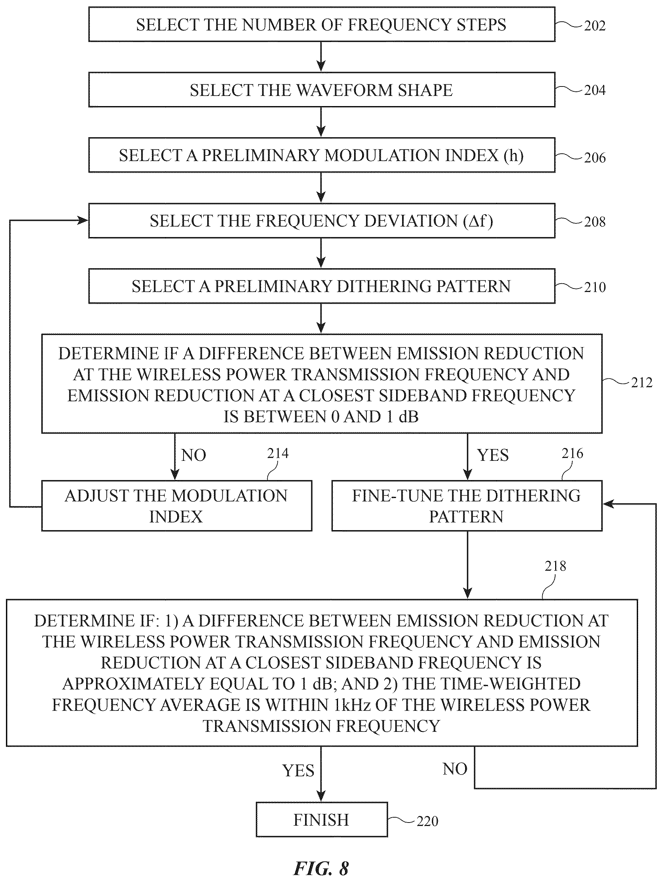

FIG. 8 is a flowchart of an illustrative method for selecting a dithering pattern for a given wireless power transmission frequency. During the operations of block 202, the number of frequency steps may be selected. The modulation frequency fₘ is a function of the number of steps selected. For a given wireless power transmission frequency f_{c}, the modulation frequency fₘ is equal to the wireless power transmission frequency divided by the number of steps (N) selected (e.g., fₘ = f_{c}/N). The number of steps may desirably be high to produce a smaller modulation frequency which is advantageous for mitigating the magnitude of Δf. However, the number of steps may be sufficiently low to ensure that fₘ is greater than a threshold such as 9 kHz.

During the operations of block 204, the waveform shape may be selected. A stepwise function that approximates a triangular shape may be selected to ensure a smooth transition between every repeated cycle of the dithered clock signal.

During the operations of block 206, a preliminary modulation index (h) may be selected. There may be a known relationship between modulation index and sideband amplitude. A modulation index of around 1.5 may have a known sideband amplitude that is close to carrier amplitude and therefore 1.5 may be used as the preliminary modulation index. Other preliminary modulation index values may be used if desired (e.g., 1.55, 1.6, 1.65, 1.7, 1.75, 1.8, etc.).

During the operations of block 208, the frequency deviation (Δf) may be selected. The magnitude of Δf may be equal to the maximum difference between a frequency magnitude of the waveform and the wireless power transmission frequency. The preliminary modulation index selected at block 206 and the modulation frequency selected at block 202 may be used to determine frequency deviation (Δf) using the formula Δf = fₘ x h.

During the operations of block 210, a preliminary dithering pattern may be selected. The preliminary dithering pattern may include the number of frequency steps (determined at block 202) arranged in an approximately triangular step function that is centered around the wireless power transmission frequency, that has a maximum frequency approximately equal to f_{c} + Δf, and that has a minimum frequency approximately equal to f_{c} - Δf. In the preliminary dithering pattern, the change in frequency magnitude between adjacent frequency steps may be approximately constant (e.g., the change in denominator used to define the modulating waveform may be constant). As one example, the preliminary dithering pattern may include N/2+1 falling steps and N/2-1 rising steps (as in the example of FIG. 5). The rising steps may be shifted relative to the falling steps (as discussed in connection with FIGS. 5 and 6).

During the operations of block 212, the emission spectrum associated with the preliminary dithering pattern may be assessed. In particular, it may be determined if a difference between emission reduction at the wireless power transmission frequency and emission reduction at a closest sideband frequency is between 0 and 1 dB. Consider the emission spectrum of FIG. 7. During the operations of block 212, it may be determined if difference 108 is greater than difference 106 by between 0 and 1 dB and/or if difference 110 is greater than difference 106 by between 0 and 1 dB. If this criterion is met, the method may proceed to the operations of block 216. If this criterion is met, the method may proceed to the operations of block 214.

During the operations of block 214, the modulation index (h) may be adjusted. After adjusting the modulation index, the method may return to the operations of block 208 and the operations of blocks 208, 210, and 212 may be repeated. The modulation index may be adjusted until the criterion at block 212 is satisfied.

When the criterion of block 212 is satisfied, the method proceeds to the operations of block 216. During the operations of block 216, the dithering pattern may be fine-tuned. Fine-tuning the dithering pattern may include adjusting one or more of the highest and lowest frequencies from the preliminary dithering pattern.

During the operations of block 218, the fine-tuned dithering pattern may be assessed to determine if: 1) a difference between emission reduction at the wireless power transmission frequency and emission reduction at a closest sideband frequency is approximately equal to 1 dB; and 2) the time-weighted frequency average is within 1 kHz of the designated wireless power transmission frequency.

Regarding criterion #1, consider the emission spectrum of FIG. 7. During the operations of block 218, it may be determined if difference 108 is greater than difference 106 by approximately 1 dB (e.g., between 0.9 and 1.1 dB, between 0.8 and 1.2 dB, between 0.9 and 1.2 dB, between 1 and 1.2 dB, etc.) and/or if difference 110 is greater than difference 106 by approximately 1 dB (e.g., between 0.9 and 1.1 dB, between 0.8 and 1.2 dB, between 0.9 and 1.2 dB, between 1 and 1.2 dB, etc.).

Regarding criterion #2, the time-weighted frequency average of the fine-tuned dithering pattern may be calculated. It may be determined if the time-weighted frequency average is within 1 kHz (or some other threshold) of the designated wireless power transmission frequency (e.g., 360 kHz, 128 kHz, etc.).

If both criteria of block 218 are satisfied, the method may proceed to block 220 and be finished. The dithering pattern most recently output during the operations of block 216 may be used as the dithering pattern during wireless power transfer operations in PTX 12.

If one or both of the criteria of block 218 are not satisfied, the method may return to block 216 for additional fine-tuning. The operations of blocks 216 and 218 may be repeated until the dithering pattern meets the criteria of block 218.

In accordance with an embodiment, an electronic device includes an inverter configured to receive switching signals based on a dithered clock signal and output corresponding alternating current signals to a wireless power transfer coil, and control circuitry configured to generate the dithered clock signal, where the dithered clock signal has a plurality of frequency steps during a repeated cycle of the dithered clock signal, the repeated cycle of the dithered clock signal includes a step function that approximates a triangular waveform, and the dithered clock signal has a unique frequency magnitude at every one of the plurality of frequency steps during the repeated cycle.

In accordance with another embodiment, the plurality of frequency steps during the repeated cycle optionally includes thirty-two frequency steps during the repeated cycle.

In accordance with another embodiment, the dithered clock signal is optionally at each frequency step for a respective duration of time before progressing to a subsequent frequency step and the duration of time for each one of the plurality of frequency steps is optionally unique.

In accordance with another embodiment, during each repeated cycle, the dithered clock signal is optionally at each frequency step for only one period at that frequency step before progressing to a subsequent frequency step.

In accordance with another embodiment, the triangular waveform is optionally centered around a frequency designated as the wireless power transmission frequency of the electronic device.

In accordance with another embodiment, a time-weighted average of the frequency magnitude of the dithered clock signal is within 1 kHz of a frequency, designated as the wireless power transmission frequency of the electronic device, during the repeated cycle.

In accordance with another embodiment, the wireless power transmission frequency is optionally between 127-129 kHz or 359-361 kHz.

In accordance with another embodiment, the repeated cycle repeats at a modulation frequency that is optionally greater than 9 kHz.

In accordance with another embodiment, the modulation frequency is optionally less than 20 kHz.

In accordance with another embodiment, the dithered clock signal optionally has a maximum frequency magnitude, where there is optionally a difference between the maximum frequency magnitude and the wireless power transmission frequency, and the difference divided by the modulation frequency is optionally between 1.6 and 1.7.

In accordance with another embodiment, during a first subset of the plurality of frequency steps, the frequency magnitude optionally decreases over time, during a second subset of the plurality of frequency steps, the frequency magnitude optionally increases over time, and each one of the second subset of the plurality of frequency steps optionally has a frequency magnitude that is between respective frequency magnitudes of a respective two of the first subset of the plurality of frequency steps.

In accordance with another embodiment, the triangular waveform is optionally centered around a frequency designated as the wireless power transmission frequency of the electronic device and the dithered clock signal optionally has a maximum emission magnitude at the wireless power transmission frequency.

In accordance with another embodiment, the triangular waveform is optionally centered around a frequency designated as the wireless power transmission frequency of the electronic device, an undithered version of the clock signal at the wireless power transmission frequency optionally has a first maximum emission magnitude at the wireless power transmission frequency, the dithered clock signal optionally has a second maximum emission magnitude at the wireless power transmission frequency and an additional emission magnitude at a sideband frequency, the second maximum emission magnitude is optionally less than the first maximum emission magnitude by a first difference, the additional emission magnitude is optionally less than the first maximum emission magnitude by a second difference, the second difference is optionally greater than the first difference, and the second difference is optionally within 1.2 dB of the first difference.

In accordance with an embodiment, an electronic device includes an inverter configured to receive switching signals based on a dithered clock signal and output corresponding alternating current signals to a wireless power transfer coil, and control circuitry configured to generate the dithered clock signal, where the dithered clock signal has a plurality of frequency steps during a repeated cycle of the dithered clock signal, the repeated cycle of the dithered clock signal includes a step function that approximates a triangular waveform, during a first subset of the plurality of frequency steps, the frequency magnitude decreases over time, during a second subset of the plurality of frequency steps, the frequency magnitude increases over time, and each one of the second subset of the plurality of frequency steps has a frequency magnitude that is between respective frequency magnitudes of a respective two of the first subset of the plurality of frequency steps.

In accordance with another embodiment, the control circuitry optionally generates the dithered clock signal by dividing a system clock signal by a denominator, where each one of the plurality of frequency steps optionally has a respective denominator, and each one of the second subset of the plurality of frequency steps optionally has a denominator that is shifted by a same amount relative to a respective denominator of one of the first subset of the plurality of frequency steps.

In accordance with another embodiment, a time-weighted average of the frequency magnitude of the dithered clock signal is optionally within 1 kHz of a frequency, designated as the wireless power transmission frequency of the electronic device, during the repeated cycle and where the wireless power transmission frequency is optionally between 127-129 kHz or 359-361 kHz.

In accordance with another embodiment, the repeated cycle repeats at a modulation frequency that is optionally between 9 kHz and 20 kHz.

In accordance with an embodiment, an electronic device includes an inverter configured to receive switching signals based on a dithered clock signal and output corresponding alternating current signals to a wireless power transfer coil, and control circuitry configured to generate the dithered clock signal, where the dithered clock signal has a plurality of frequency steps during a repeated cycle of the dithered clock signal, the repeated cycle of the dithered clock signal includes a step function that approximates a triangular waveform, the triangular waveform is centered around a frequency designated as the wireless power transmission frequency of the electronic device, an undithered version of the clock signal at the wireless power transmission frequency has a first maximum emission magnitude at the wireless power transmission frequency, the dithered clock signal has a second maximum emission magnitude at the wireless power transmission frequency and an additional emission magnitude at a sideband frequency, the second maximum emission magnitude is less than the first maximum emission magnitude by a first difference, the additional emission magnitude is less than the first maximum emission magnitude by a second difference, the second difference is greater than the first difference, and the second difference is within 1.2 dB of the first difference.

In accordance with another embodiment, the sideband frequency is optionally a first sideband frequency and the additional emission magnitude is a first emission magnitude, the dithered clock signal optionally has a second emission magnitude at a second sideband frequency, the first sideband frequency is optionally less than the wireless power transmission frequency, the second sideband frequency is optionally greater than the wireless power transmission frequency, the second emission magnitude is optionally less than the first maximum emission magnitude by a third difference, the third difference is optionally greater than the first difference, and the third difference is optionally within 1.2 dB of the first difference.

In accordance with another embodiment, the dithered clock signal optionally has a unique frequency magnitude at every one of the plurality of frequency steps during the repeated cycle.

The foregoing is merely illustrative and various modifications can be made to the described embodiments. The foregoing embodiments may be implemented individually or in any combination.

Exemplary embodiments of the present disclosure are set out in the following items:
1. An electronic device comprising:
   an inverter configured to receive switching signals based on a dithered clock signal and output corresponding alternating current signals to a wireless power transfer coil; and
   control circuitry configured to generate the dithered clock signal, wherein:
      the dithered clock signal has a plurality of frequency steps during a repeated cycle of the dithered clock signal;
      the repeated cycle of the dithered clock signal comprises a step function that approximates a triangular waveform; and
      the dithered clock signal has a unique frequency magnitude at every one of the plurality of frequency steps during the repeated cycle.
2. The electronic device of item 1, wherein the plurality of frequency steps during the repeated cycle comprises thirty-two frequency steps during the repeated cycle.
3. The electronic device of any of items 1-2, wherein the dithered clock signal is at each frequency step for a respective duration of time before progressing to a subsequent frequency step and wherein the duration of time for each one of the plurality of frequency steps is unique.
4. The electronic device of any of items 1-3, wherein, during each repeated cycle, the dithered clock signal is at each frequency step for only one period at that frequency step before progressing to a subsequent frequency step.
5. The electronic device of any of items 1-4, wherein the triangular waveform is centered around a frequency designated as the wireless power transmission frequency of the electronic device.
6. The electronic device of any of items 1-5, wherein a time-weighted average of the frequency magnitude of the dithered clock signal is within 1 kHz of a frequency, designated as the wireless power transmission frequency of the electronic device, during the repeated cycle.
7. The electronic device of item 6, wherein the wireless power transmission frequency is between 127-129 kHz or 359-361 kHz.
8. The electronic device of any of items 6-7, wherein the repeated cycle repeats at a modulation frequency that is greater than 9 kHz.
9. The electronic device of any of items 6-8, wherein the modulation frequency is less than 20 kHz.
10. The electronic device of any of items 6-9, wherein the dithered clock signal has a maximum frequency magnitude, wherein there is a difference between the maximum frequency magnitude and the wireless power transmission frequency, and wherein the difference divided by the modulation frequency is between 1.6 and 1.7.
11. The electronic device of any of items 1-10, wherein:
   during a first subset of the plurality of frequency steps, the frequency magnitude decreases over time;
   during a second subset of the plurality of frequency steps, the frequency magnitude increases over time; and
   each one of the second subset of the plurality of frequency steps has a frequency magnitude that is between respective frequency magnitudes of a respective two of the first subset of the plurality of frequency steps.
12. The electronic device of any of items 1-11, wherein:
   the triangular waveform is centered around a frequency designated as the wireless power transmission frequency of the electronic device; and
   the dithered clock signal has a maximum emission magnitude at the wireless power transmission frequency.
13. The electronic device of any of items 1-12, wherein:
   the triangular waveform is centered around a frequency designated as the wireless power transmission frequency of the electronic device;
   an undithered version of the clock signal at the wireless power transmission frequency has a first maximum emission magnitude at the wireless power transmission frequency;
   the dithered clock signal has a second maximum emission magnitude at the wireless power transmission frequency and an additional emission magnitude at a sideband frequency;
   the second maximum emission magnitude is less than the first maximum emission magnitude by a first difference;
   the additional emission magnitude is less than the first maximum emission magnitude by a second difference;
   the second difference is greater than the first difference; and
   the second difference is within 1.2 dB of the first difference.
14. An electronic device comprising:
   an inverter configured to receive switching signals based on a dithered clock signal and output corresponding alternating current signals to a wireless power transfer coil; and
   control circuitry configured to generate the dithered clock signal, wherein:
      the dithered clock signal has a plurality of frequency steps during a repeated cycle of the dithered clock signal;
      the repeated cycle of the dithered clock signal comprises a step function that approximates a triangular waveform;
      during a first subset of the plurality of frequency steps, the frequency magnitude decreases over time;
      during a second subset of the plurality of frequency steps, the frequency magnitude increases over time; and
      each one of the second subset of the plurality of frequency steps has a frequency magnitude that is between respective frequency magnitudes of a respective two of the first subset of the plurality of frequency steps.
15. The electronic device of item 14, wherein the control circuitry generates the dithered clock signal by dividing a system clock signal by a denominator, wherein each one of the plurality of frequency steps has a respective denominator, and wherein each one of the second subset of the plurality of frequency steps has a denominator that is shifted by a same amount relative to a respective denominator of one of the first subset of the plurality of frequency steps.
16. The electronic device of any of items 14-15, wherein a time-weighted average of the frequency magnitude of the dithered clock signal is within 1 kHz of a frequency, designated as the wireless power transmission frequency of the electronic device, during the repeated cycle and wherein the wireless power transmission frequency is between 127-129 kHz or 359-361 kHz.
17. The electronic device of any of items 14-16, wherein the repeated cycle repeats at a modulation frequency that is between 9 kHz and 20 kHz.
18. An electronic device comprising:
   an inverter configured to receive switching signals based on a dithered clock signal and output corresponding alternating current signals to a wireless power transfer coil; and
   control circuitry configured to generate the dithered clock signal, wherein:
      the dithered clock signal has a plurality of frequency steps during a repeated cycle of the dithered clock signal;
      the repeated cycle of the dithered clock signal comprises a step function that approximates a triangular waveform;
      the triangular waveform is centered around a frequency designated as the wireless power transmission frequency of the electronic device;
      an undithered version of the clock signal at the wireless power transmission frequency has a first maximum emission magnitude at the wireless power transmission frequency;
      the dithered clock signal has a second maximum emission magnitude at the wireless power transmission frequency and an additional emission magnitude at a sideband frequency;
      the second maximum emission magnitude is less than the first maximum emission magnitude by a first difference;
      the additional emission magnitude is less than the first maximum emission magnitude by a second difference;
      the second difference is greater than the first difference; and
      the second difference is within 1.2 dB of the first difference.
19. The electronic device of item 18, wherein:
   the sideband frequency is a first sideband frequency and the additional emission magnitude is a first emission magnitude;
   the dithered clock signal has a second emission magnitude at a second sideband frequency;
   the first sideband frequency is less than the wireless power transmission frequency;
   the second sideband frequency is greater than the wireless power transmission frequency;
   the second emission magnitude is less than the first maximum emission magnitude by a third difference;
   the third difference is greater than the first difference; and
   the third difference is within 1.2 dB of the first difference.
20. The electronic device of any of items 18-19, wherein the dithered clock signal has a unique frequency magnitude at every one of the plurality of frequency steps during the repeated cycle.

## Claims

1. An electronic device comprising:
an inverter configured to receive switching signals based on a dithered clock signal and output corresponding alternating current signals to a wireless power transfer coil; and
control circuitry configured to generate the dithered clock signal, wherein:
the dithered clock signal has a plurality of frequency steps during a repeated cycle of the dithered clock signal;
the repeated cycle of the dithered clock signal comprises a step function that approximates a triangular waveform; and
the dithered clock signal has a unique frequency magnitude at every one of the plurality of frequency steps during the repeated cycle.

2. The electronic device of claim 1, wherein the plurality of frequency steps during the repeated cycle comprises thirty-two frequency steps during the repeated cycle.

3. The electronic device of any of claims 1-2, wherein the dithered clock signal is at each frequency step for a respective duration of time before progressing to a subsequent frequency step and wherein the duration of time for each one of the plurality of frequency steps is unique.

4. The electronic device of any of claims 1-3, wherein, during each repeated cycle, the dithered clock signal is at each frequency step for only one period at that frequency step before progressing to a subsequent frequency step.

5. The electronic device of any of claims 1-4, wherein the triangular waveform is centered around a frequency designated as the wireless power transmission frequency of the electronic device.

6. The electronic device of any of claims 1-5, wherein a time-weighted average of the frequency magnitude of the dithered clock signal is within 1 kHz of a frequency, designated as the wireless power transmission frequency of the electronic device, during the repeated cycle.

7. The electronic device of claim 6, wherein the wireless power transmission frequency is between 127-129 kHz or 359-361 kHz.

8. The electronic device of any of claims 6-7, wherein the repeated cycle repeats at a modulation frequency that is greater than 9 kHz.

9. The electronic device of any of claims 6-8, wherein the modulation frequency is less than 20 kHz.

10. The electronic device of any of claims 6-9, wherein the dithered clock signal has a maximum frequency magnitude, wherein there is a difference between the maximum frequency magnitude and the wireless power transmission frequency, and wherein the difference divided by the modulation frequency is between 1.6 and 1.7.

11. The electronic device of any of claims 1-10, wherein:
during a first subset of the plurality of frequency steps, the frequency magnitude decreases over time;
during a second subset of the plurality of frequency steps, the frequency magnitude increases over time; and
each one of the second subset of the plurality of frequency steps has a frequency magnitude that is between respective frequency magnitudes of a respective two of the first subset of the plurality of frequency steps.

12. The electronic device of any of claims 1-11, wherein:
the triangular waveform is centered around a frequency designated as the wireless power transmission frequency of the electronic device; and
the dithered clock signal has a maximum emission magnitude at the wireless power transmission frequency.

13. The electronic device of any of claims 1-13, wherein:
the triangular waveform is centered around a frequency designated as the wireless power transmission frequency of the electronic device;
an undithered version of the clock signal at the wireless power transmission frequency has a first maximum emission magnitude at the wireless power transmission frequency;
the dithered clock signal has a second maximum emission magnitude at the wireless power transmission frequency and an additional emission magnitude at a sideband frequency;
the second maximum emission magnitude is less than the first maximum emission magnitude by a first difference;
the additional emission magnitude is less than the first maximum emission magnitude by a second difference;
the second difference is greater than the first difference; and
the second difference is within 1.2 dB of the first difference.

14. An electronic device comprising:
an inverter configured to receive switching signals based on a dithered clock signal and output corresponding alternating current signals to a wireless power transfer coil; and
control circuitry configured to generate the dithered clock signal, wherein:
the dithered clock signal has a plurality of frequency steps during a repeated cycle of the dithered clock signal;
the repeated cycle of the dithered clock signal comprises a step function that approximates a triangular waveform;
during a first subset of the plurality of frequency steps, the frequency magnitude decreases over time;
during a second subset of the plurality of frequency steps, the frequency magnitude increases over time; and
each one of the second subset of the plurality of frequency steps has a frequency magnitude that is between respective frequency magnitudes of a respective two of the first subset of the plurality of frequency steps.

15. An electronic device comprising:
an inverter configured to receive switching signals based on a dithered clock signal and output corresponding alternating current signals to a wireless power transfer coil; and
control circuitry configured to generate the dithered clock signal, wherein:
the dithered clock signal has a plurality of frequency steps during a repeated cycle of the dithered clock signal;
the repeated cycle of the dithered clock signal comprises a step function that approximates a triangular waveform;
the triangular waveform is centered around a frequency designated as the wireless power transmission frequency of the electronic device;
an undithered version of the clock signal at the wireless power transmission frequency has a first maximum emission magnitude at the wireless power transmission frequency;
the dithered clock signal has a second maximum emission magnitude at the wireless power transmission frequency and an additional emission magnitude at a sideband frequency;
the second maximum emission magnitude is less than the first maximum emission magnitude by a first difference;
the additional emission magnitude is less than the first maximum emission magnitude by a second difference;
the second difference is greater than the first difference; and
the second difference is within 1.2 dB of the first difference.
